# FASCICULE DE BREVET EUROPEEN

(11) **EP 2 438 024 B1**
(45) Date de publication et mention de la délivrance du brevet: **23.12.2020**
(21) Numéro de dépôt: 10734226.3
(22) Date de dépôt: 04.06.2010
(51) Int. Cl.: C03C 17/23, C03C 17/245, C03C 17/34, C03C 17/36, C23C 14/08, C23C 14/58

(54) **PROCEDE DE DEPOT DE COUCHE MINCE**
VERFAHREN ZUR ABSCHEIDUNG EINES DÜNNEN FILMS
METHOD FOR DEPOSITING A THIN FILM

(30) Priorité: 05.06.2009 FR 0953742
(43) Date de publication de la demande: 11.04.2012
(73) Titulaire: SAINT-GOBAIN GLASS FRANCE, 92400 Courbevoie (FR)
(72) Inventeur: PETER, Emmanuelle, 13090 Aix en Provence (FR); KHARCHENKO, Andriy, 91120 Palaiseau (FR); NADAUD, Nicolas, 75013 Paris (FR)
(74) Mandataire: Saint-Gobain Recherche
(86) Numéro de dépôt international: PCT/FR2010/051097
(87) Numéro de publication internationale: WO 2010/139908

(56) Documents cités:
- DE-A1-102007 052 782
- GB-A- 2 428 689
- JP-A- 11 106 935
- SANO N ET AL: "Activation of implanted boron atoms in silicon wafers by infrared semiconductor laser annealing using carbon films as optical absorption layers" JAPANESE JOURNAL OF APPLIED PHYSICS, JAPAN SOCIETY OF APPLIED PHYSICS, JP LNKD- DOI:10.1143/JJAP.46.L620, vol. 46, no. 25, 1 juillet 2007 (2007-07-01), pages L620-L622, XP001517833 ISSN: 0021-4922
- NAGASE ET AL: "A novel approach to prepare zinc oxide films : excimer laser irradiation of sol-gel precursor films" THIN SOLID FILMS, vol. 357, 1999, pages 151-158, XP002565783
- NARAZAKI A ET AL: "IMPROVEMENT IN ELECTRICAL CONDUCTIVITY OF INDIUM TIN OXIDE FILMS PREPARED VIA PULSED LASER DEPOSITION ON ELECTRIC-FIELD-APPLIED SUBSTRATES" JAPANESE JOURNAL OF APPLIED PHYSICS, JAPAN SOCIETY OF APPLIED PHYSICS, TOKYO,JP, vol. 41, no. 6A, PART 01, 1 juin 2002 (2002-06-01), page 3760/3761, XP001163452 ISSN: 0021-4922

## Description

L'invention se rapporte au domaine des couches minces inorganiques, notamment déposées sur des substrats. Elle concerne plus particulièrement un procédé de traitement thermique de couches minces transparentes électro-conductrices dans le but de réduire leur résistivité.

De nombreuses couches minces sont déposées sur des substrats, notamment en verre plat ou faiblement bombé, afin de conférer aux matériaux obtenus des propriétés particulières : propriétés optiques, par exemple de réflexion ou d'absorption de rayonnements d'un domaine de longueurs d'onde donné, propriétés de conduction électrique particulière, ou encore propriétés liées à la facilité de nettoyage ou à la possibilité pour le matériau de s'auto-nettoyer.

Certaines couches, généralement à base d'oxydes semi-conducteurs, ont la particularité d'être transparentes et néanmoins électro-conductrices. Ces couches sont souvent désignées par leur acronyme anglais « TCO », pour « Transparent Conductive Oxides ». Leur épaisseur varie généralement de quelques nanomètres à quelques centaines de nanomètres, d'où leur qualificatif de « minces ». Dans le texte, on utilise indifféremment les termes de « couche transparente et électro-conductrice à base d'au moins un oxyde » et les termes de « couche à base de TCO ».

A titre d'exemples, on peut citer les couches minces à base d'oxydes mixtes d'étain et d'indium (appelées « ITO »), à base d'oxydes mixtes d'indium et de zinc (appelées « IZO »), à base d'oxyde de zinc dopé au gallium ou à l'aluminium, à base d'oxyde de titane dopé au niobium, à base de stannate de cadmium ou de zinc, à base d'oxyde d'étain dopé au fluor et/ou à l'antimoine. Ces différentes couches sont employées dans de nombreux systèmes où les propriétés de transparence et de conductivité électrique sont nécessaires : écrans à cristaux liquides (LCD), capteurs solaires ou photovoltaïques, dispositifs électrochromes ou électroluminescents...

Dans une cellule photovoltaïque, un système photovoltaïque à matériau photovoltaïque qui produit de l'énergie électrique sous l'effet d'un rayonnement incident est positionné entre un substrat de face arrière et un substrat de face avant, ce substrat de face avant étant le premier substrat qui est traversé par le rayonnement incident avant qu'il n'atteigne le matériau photovoltaïque.

Dans la cellule photovoltaïque, le substrat de face avant comporte d'une manière habituelle en dessous d'une surface principale tournée vers le matériau photovoltaïque un revêtement électrode transparent en contact électrique avec le matériau photovoltaïque disposé dessous lorsque l'on considère que la direction principale d'arrivée du rayonnement incident est par le dessus.

Dans le cas des matériaux photovoltaïques à base de silicium (par exemple silicium amorphe ou microcristallin), ce revêtement électrode de face avant constitue ainsi, en général, la borne négative (ou collectant les trous) de la cellule solaire. Bien sûr, la cellule solaire comporte aussi sur le substrat de face arrière un revêtement électrode qui constitue alors la borne positive (ou collectant les électrons) de la cellule solaire, mais en général, le revêtement électrode du substrat de face arrière n'est pas transparent. Pour les matériaux photovoltaïques à base de tellure de cadmium, le revêtement électrode de face avant constitue en général la borne positive de la cellule solaire.

De telles couches à base de TCO peuvent donc, à titre d'exemple, être employées comme revêtements électrodes de face avant.

Quelle que soit la nature de la couche à base de TCO ou son application, on cherche généralement à maximiser sa conductivité et donc à minimiser sa résistivité.

L'intérêt de disposer de couches à faible résistivité est que l'on peut réduire l'épaisseur de la couche pour une même résistance, ou que l'on peut réduire la résistance par rapport à une couche de même épaisseur.

En particulier dans les applications photovoltaïques, et pour obtenir la faible résistance souhaitée (typiquement de 8 à 10 Ohms), le revêtement TCO doit être déposé à une épaisseur physique relativement importante, de l'ordre de 500 à 1 000 nm et même parfois plus, ce qui coûte cher eu égard au prix de ces matériaux lorsqu'ils sont déposés en couches minces.

Un autre inconvénient majeur des revêtements TCO réside dans le fait que pour un matériau choisi, son épaisseur physique est toujours un compromis entre conduction électrique et transparence car l'épaisseur est corrélée avec la conductivité mais inversement corrélée avec la transparence. Or une forte transparence est souvent requise, notamment dans le domaine du photovoltaïque, car il est important que le maximum de rayonnement puisse atteindre la cellule. Il importe en particulier que la couche soit la moins absorbante possible dans le domaine de longueur d'onde où l'efficacité quantique du matériau photovoltaïque considéré est la plus forte. Il est rappelé ici que l'efficacité quantique QE est d'une manière connue l'expression de la probabilité (entre 0 et 1) qu'un photon incident avec une longueur d'onde donnée soit transformé en paire électron-trou. La longueur d'onde maximum d'absorption λₘ, c'est-à-dire la longueur d'onde à laquelle l'efficacité quantique est maximum est de l'ordre de 640 nm pour du tellure de cadmium, 540 nm pour du silicium amorphe et de l'ordre de 710 nm pour du silicium microcristallin.

Toute diminution de l'épaisseur de la couche, à résistance constante, est donc avantageuse, que ce soit pour des raisons économiques ou des raisons de transmission optique.

Un procédé couramment employé à l'échelle industrielle pour le dépôt de couches minces, notamment sur substrat verrier, est le procédé de pulvérisation cathodique assisté par champ magnétique, appelé procédé « magnétron ». Dans ce procédé, un plasma est créé sous un vide poussé au voisinage d'une cible comprenant les éléments chimiques à déposer. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. L'avantage majeur de ce procédé réside dans la possibilité de déposer sur une même ligne un empilement très complexe de couches en faisant successivement défiler le substrat sous différentes cibles, ce généralement dans un seul et même dispositif.

Lors de la mise en œuvre industrielle du procédé magnétron, le substrat reste à température ambiante ou subit une élévation de température modérée (moins de 80°C), particulièrement lorsque la vitesse de défilement du substrat est élevée (ce qui est généralement recherché pour des raisons économiques). Ce qui peut paraître un avantage constitue toutefois un inconvénient dans le cas des couches précitées, car les faibles températures impliquées ne permettent généralement pas d'obtenir une résistivité suffisamment faible. Des traitements thermiques se révèlent alors nécessaires pour obtenir la résistivité désirée.

Des traitements thermiques possibles consistent à réchauffer le substrat soit pendant le dépôt, soit à l'issue du dépôt, en sortie de ligne magnétron. Le plus généralement, des températures d'au moins 200°C ou 300°C sont nécessaires.

Le chauffage du substrat dans les lignes magnétron industrielles (pendant le dépôt) s'est toutefois révélé malaisé à mettre en œuvre, en particulier car les transferts de chaleur sous vide, nécessairement de nature radiative, sont difficiles à maîtriser et impliquent un coût élevé dans le cas des substrats de grande taille, de plusieurs mètres de largeur. Dans le cas de substrats de verre de faible épaisseur, ce type de traitement implique souvent des risques de casse élevés.

Le chauffage du substrat revêtu à l'issue du dépôt, par exemple en plaçant le substrat dans un four ou une étuve ou en soumettant le substrat au rayonnement infrarouge issu de dispositifs de chauffage conventionnels tels que des lampes infrarouge, présente également des inconvénients car ces différents procédés contribuent à chauffer sans discernement le substrat et la couche mince. Le chauffage du substrat à des températures supérieures à 150°C est susceptible de générer des casses dans le cas de substrats de grande taille (plusieurs mètres de large) car il est impossible d'assurer une température identique sur toute la largeur du substrat. Le chauffage des substrats ralentit également l'ensemble du procédé, car il est nécessaire d'attendre leur refroidissement complet avant d'envisager leur découpe ou leur stockage, qui a généralement lieu en empilant les substrats les uns sur les autres. Un refroidissement très contrôlé est en outre indispensable pour éviter la génération de contraintes au sein du verre, et donc la possibilité de casses. Un tel refroidissement très contrôlé étant très coûteux, le recuit n'est généralement pas suffisamment contrôlé pour éliminer les contraintes thermiques au sein du verre, ce qui génère un nombre accru de casses en ligne. Le recuit présente en outre l'inconvénient de rendre la découpe du verre plus difficile, les fissures ayant une tendance moins forte à se propager linéairement.

Le chauffage des substrats a lieu dans le cas où les vitrages sont bombés et/ou trempés, car un réchauffage du verre au-delà de sa température de ramollissement (généralement à plus de 600°C, voire 700°C pendant quelques minutes) est effectué. La trempe ou le bombage permet donc de diminuer fortement la résistivité des couches à base de TCO. Il serait toutefois coûteux de soumettre à de tels traitements tous les vitrages. En outre, les vitrages trempés ne peuvent plus être découpés, et certains empilements de couches minces ne supportent pas les températures élevées subies lors de la trempe du verre.

La demande de brevet WO 2008/096089, déposée par la demanderesse, décrit un procédé de recuit rapide qui consiste à apporter à la couche une puissance par unité de surface extrêmement élevée. La couche est chauffée extrêmement rapidement, sans que la chaleur ait le temps de diffuser au sein du substrat. Il est ainsi possible de traiter thermiquement la couche mince sans chauffer significativement le substrat, en limitant de ce fait le risque de casse lié au choc thermique. Pour des couches de type TCO, les procédés envisagés sont des procédés mettant en œuvre des flammes, une torche plasma, ou un laser CO₂, dont la longueur d'onde est de 10,6 micromètres. Ces procédés permettent d'atteindre des résistivités qui ne pouvaient être préalablement atteintes que par la trempe du verre ou par un dépôt à haute température. La technique de flammage s'accompagne généralement d'un bombage transitoire du verre susceptible d'affecter l'homogénéité du traitement.

DE 102007052782 décrit un procédé de traitement thermique d'une couche TCO utilisant une ligne laser.

L'invention a pour but de proposer un procédé amélioré permettant d'atteindre des résistivités encore plus faibles et d'obvier aux problèmes susmentionnés, tout en conservant une forte transmission dans les domaines du visible et du proche infrarouge.

A cet effet, l'invention a pour objet un procédé d'obtention d'un substrat revêtu sur une première face d'au moins une couche mince transparente et électro-conductrice à base d'au moins un oxyde, comprenant les étapes suivantes :
- on dépose ladite au moins une couche mince sur ledit substrat,
- on soumet ladite au moins une couche mince à une étape de traitement thermique dans laquelle on irradie ladite au moins une couche à l'aide d'un rayonnement possédant une longueur d'onde comprise entre 500 et 2000 nm et focalisé sur une zone de ladite au moins une couche dont une dimension au moins n'excède pas 10 cm, ledit rayonnement étant issu d'au moins un dispositif de rayonnement placé en regard de ladite au moins une couche, un déplacement relatif étant créé entre ledit dispositif de rayonnement et ledit substrat de manière à traiter la surface souhaitée, ledit traitement thermique étant tel que la résistivité de ladite au moins une couche est diminuée lors du traitement, ledit procédé étant caractérisé en ce que ladite au moins une couche mince est surmontée, avant l'étape de traitement thermique, d'une couche mince à base de carbone d'épaisseur inférieure à 5 nm.

Il s'est avéré que ce choix de longueurs d'onde permettait d'améliorer de manière très substantielle l'efficacité du traitement selon l'invention, et permettait d'obtenir des couches de résistivité beaucoup plus faible que celles obtenues par un traitement au laser à CO₂ décrit dans la demande WO 2008/096089 susmentionnée.

Le procédé selon l'invention est de préférence tel que la résistivité de la couche transparente et électro-conductrice, ou sa résistance carrée, est diminuée d'au moins 60%, voire 70% et même 75% relativement à la résistivité ou à la résistance carrée mesurée avant traitement thermique.

Le procédé selon l'invention permet ainsi d'atteindre des résistivités très faibles, notamment inférieures ou égales à 7.10⁻⁴ Q.cm, notamment 6.10⁻⁴ Ω.cm, voire même à 4.10⁻⁴ Ω.cm ou à 3.10⁻⁴ Ω.cm, pour des couches en oxyde de zinc dopé à l'aluminium et/ou au gallium. Il est ainsi possible d'obtenir des couches dont la résistance carrée est inférieure ou égale à 10 Ω pour une épaisseur inférieure ou égale à 700 nm ou 600 nm, voire inférieure ou égale à 400 nm ou même 300 nm.

Le traitement selon l'invention permet également d'augmenter la transmission lumineuse du substrat revêtu, d'au moins 5%, voire 10% absolus. La transmission lumineuse est calculée selon la norme ISO 9050 :2003 à partir du spectre en transmission et ramenée à une épaisseur de verre de 3,2 mm. Il est ainsi possible pour des substrats de verre revêtus de la couche à base de TCO d'obtenir des transmissions lumineuses supérieures à 80%, notamment 83%.

L'absorption lumineuse est donc fortement réduite, de préférence à des niveaux tels que l'absorption d'une couche d'oxyde de zinc dopé à l'aluminium et/ou au gallium est inférieure à 1,2%, notamment 1,0% pour une épaisseur de couche de 100 nm. L'absorption lumineuse de la couche est définie comme étant égale à la valeur de 100% à laquelle sont soustraites la transmission lumineuse du substrat revêtu, la réflexion lumineuse côté substrat (côté de la face opposée à la couche) et l'absorption lumineuse du substrat non-revêtu. L'absorption lumineuse du substrat non-revêtu correspond quant à elle à la valeur de 100% à laquelle sont soustraites la transmission lumineuse et la réflexion lumineuse du substrat non revêtu. Comme dans l'ensemble du texte, les transmissions lumineuses et les réflexions lumineuses sont calculées selon la norme ISO 9050 :2003 à partir respectivement des spectres en transmission et réflexion.

Le procédé selon l'invention permet donc d'obtenir des couches, en particulier en oxyde de zinc dopé à l'aluminium ou au gallium, présentant à la fois une faible résistivité ou résistance carrée et une faible absorption lumineuse (donc une forte transmission lumineuse). A titre d'exemple, il est ainsi possible d'obtenir des substrats en verre revêtus d'une couche d'oxyde de zinc dopé à l'aluminium ou au gallium, dont l'épaisseur est inférieure ou égale à 600 nm et la résistance carrée inférieure ou égale à 10 Ω, la transmission lumineuse du substrat revêtu étant supérieure ou égale à 80%. Il est également possible d'obtenir des substrats en verre revêtus d'une couche d'oxyde de zinc dopé à l'aluminium ou au gallium, dont l'épaisseur est inférieure ou égale à 400 nm et la résistance carrée inférieure ou égale à 10 Ω, la transmission lumineuse du substrat revêtu étant supérieure ou égale à 83%. La couche mince d'oxyde de zinc dopé à l'aluminium et/ou au gallium présente de préférence, après traitement thermique, une résistivité inférieure ou égale à 7.10⁻⁴ Ω.cm, notamment 6.10⁻⁴ Ω.cm, et une absorption inférieure ou égale à 1,2%, notamment 1% pour une épaisseur de couche de 100 nm (soit inférieure ou égale à 5 ou 6% pour une couche de 500 nm d'épaisseur).

Le procédé selon l'invention ne met généralement pas en œuvre de mécanisme de cristallisation par refroidissement à partir d'un matériau fondu, d'une part car cela nécessiterait de porter la couche mince à des températures extrêmement élevées pour obtenir sa fusion, et d'autre part car cela serait susceptible de modifier les épaisseurs et/ou les indices de réfraction des couches, et donc leurs propriétés. Cela modifierait notamment leur aspect optique en générant des inhomogénéités détectables à l'œil.

Le procédé selon l'invention présente l'avantage de ne chauffer que la couche mince (ou les couches minces dans le cas d'un empilement), sans échauffement significatif de la totalité du substrat. Il n'est ainsi plus nécessaire de procéder à un refroidissement lent et contrôlé du substrat avant la découpe ou le stockage du verre. Ce procédé rend également possible l'intégration d'un dispositif de chauffage sur les lignes de production continue existantes, plus particulièrement dans l'espace situé entre la sortie de l'enceinte de dépôt sous vide de la ligne magnétron et le dispositif de stockage du verre par empilage. Il est également possible dans certains cas de réaliser le traitement selon l'invention au sein même de l'enceinte de dépôt sous vide.

Le traitement selon l'invention est de préférence tel que la température de la face du substrat opposée à la première face n'excède pas 100°C pendant le traitement. L'utilisation d'un rayonnement focalisé, notamment issu d'un rayonnement laser, présente l'avantage d'obtenir des températures inférieures à 100°C, et même souvent inférieures à 50°C au niveau de la face opposée à la première face du substrat (c'est-à-dire au niveau de la face non revêtue). Cette caractéristique particulièrement avantageuse est due au fait que le coefficient d'échange thermique est très élevé, typiquement supérieur à 400 W/(m².s). La puissance surfacique du rayonnement est même de préférence supérieure ou égale à 10 kW/cm².

Cette très forte densité d'énergie permet d'atteindre au niveau de la couche la température souhaitée extrêmement rapidement (en général en un temps inférieur ou égal à 1 seconde) et par conséquent de limiter d'autant la durée du traitement, la chaleur générée n'ayant alors pas le temps de diffuser au sein du substrat. Ainsi, chaque point de la couche mince est de préférence soumis au traitement selon l'invention (notamment porté à une température supérieure ou égale à 300°C) pour une durée généralement inférieure ou égale à 1 seconde, voire 0,5 seconde. A l'inverse, les lampes infrarouge classiquement utilisées (sans dispositif de focalisation du rayonnement) ne permettant pas d'atteindre ces fortes puissances par unité de surface, le temps de traitement doit être plus long pour atteindre les températures désirées (souvent plusieurs secondes), et le substrat est alors nécessairement porté à des températures élevées par diffusion de la chaleur, ce même si la longueur d'ondes du rayonnement est adaptée pour n'être absorbée que par la couche mince et non par le substrat.

Grâce au très fort coefficient d'échange thermique associé au procédé selon l'invention, la partie du verre située à 0,5 mm de la couche mince ne subit généralement pas de températures supérieures à 100°C. La température de la face du substrat opposée à la première face n'excède de préférence pas 50°C, notamment 30°C, pendant le traitement.

L'essentiel de l'énergie apportée est donc « utilisée » par la couche mince afin d'améliorer ses caractéristiques de résistivité.

Un autre avantage de l'invention réside dans le fait que le procédé fait subir l'équivalent d'une trempe à la couche mince ou à l'empilement de couches minces. Il arrive que certains empilements de couches minces voient leurs propriétés optiques (coordonnées colorimétriques, transmission lumineuse ou énergétique) modifiées lorsque le verre est trempé. Le procédé selon l'invention permet alors d'obtenir un verre non trempé (donc ne présentant pas en son sein un profil de contraintes spécifique au verre trempé, ce qui le rend découpable) mais présentant sensiblement les mêmes propriétés optiques que s'il avait été trempé.

Le substrat est de préférence en verre ou en matière organique polymérique. Il est de préférence transparent, incolore ou coloré, par exemple en bleu, gris ou bronze. Le verre est de préférence de type silico-sodo-calcique, mais il peut également être en verre de type borosilicate ou alumino-borosilicate. Les matières organiques polymériques préférées sont le polycarbonate ou le polyméthacrylate de méthyle. Le substrat présente avantageusement au moins une dimension supérieure ou égale à 1 m, voire 2 m et même 3 m. L'épaisseur du substrat varie généralement entre 0,5 mm et 19 mm, de préférence entre 0,7 et 9 mm, le procédé selon l'invention étant particulièrement avantageux pour les substrats les plus minces, dont l'épaisseur est inférieure ou égale à 4 mm, voire 2 mm. Le substrat peut être plan ou bombé. En particulier pour les applications photovoltaïques, il est préférable que le substrat de verre présente une excellente planéité, notamment soit tel que sur une longueur de 1 m, la différence d'altitude entre le sommet le plus haut et la vallée la plus profonde soit inférieure ou égale à 0,8 mm. De préférence, les ondulations sont de faible amplitude, au sens où sur une longueur de 30 cm, la différence d'altitude entre le sommet le plus haut et la vallée la plus profonde est inférieure ou égale à 0,3 mm.

En particulier pour les applications dans le domaine du photovoltaïque, il est préférable que le substrat soit en verre extra-clair ou ultra-clair, c'est-à-dire dont la transmission lumineuse ou énergétique est supérieure ou égale à 90%, notamment 90,5%, voire 91% et même 91,5%. La transmission lumineuse, souvent abrégée « T_{L} », est calculée selon la norme ISO 9050 :2003 et ramenée à une épaisseur de verre de 3,2 mm. La transmission énergétique, abrégée « T_{E} », est également calculée selon la norme ISO 9050 :2003 et ramené à une épaisseur de verre de 3,2 mm. De tels verres sont généralement obtenus en utilisant des matières premières appauvries en fer, de manière à ce que la teneur en oxyde de fer dans le verre final est d'au plus 0,02%, notamment 0,01%. Pour optimiser encore cette transmission, il est préférable que le rédox du verre (c'est-à-dire le rapport entre la teneur pondérale fer ferreux, exprimée en FeO et la teneur pondérale en fer total, exprimée en Fe₂O₃) soit inférieur ou égal à 20%, de préférence 10% et même nul. De tels rédox ou transmissions peuvent être obtenus en particulier en oxydant le fer à l'aide d'oxyde d'antimoine ou de cérium, ou en ajoutant au verre de l'oxyde de tungstène en une teneur pondérale comprise entre 0,1 et 2% et/ou de l'oxyde de potassium en une teneur pondérale comprise entre 1,5 et 10%, tel qu'enseigné dans les demandes FR-A-2 921 356 et FR-A-2 921 357. Il est également possible de buller un gaz oxydant dans le bain de verre après l'étape d'affinage, tel qu'enseigné dans la demande internationale WO 2009/115725.

Dans les applications photovoltaïques, les dimensions du substrat de verre sont typiquement les suivantes: 0,6^{∗}1,2 m² ou 1,1^{∗}1,3 m² ou encore 2,2^{∗}2,6 m² pour une épaisseur comprise entre 1,6 et 6 mm, notamment entre 2,9 et 4 mm.

Le substrat de verre est de préférence du type flotté, c'est-à-dire susceptible d'avoir été obtenu par un procédé consistant à déverser le verre fondu sur un bain d'étain en fusion (bain « float »). Dans ce cas, la couche à traiter peut aussi bien être déposée sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre. Il peut également être obtenu par laminage entre deux rouleaux, technique permettant en particulier d'imprimer des motifs à la surface du verre. Certains motifs peuvent être avantageux, comme explicité ci-après.

Dans un but de maximisation du rendement de la cellule photovoltaïque, le substrat est avantageusement revêtu d'un revêtement antireflets sur sa face opposée à la couche mince à base de TCO. Ce revêtement peut comprendre une couche (par exemple à base de silice poreuse à bas indice de réfraction) ou plusieurs couches : dans ce dernier cas un empilement de couches à base de matériau diélectrique alternant des couches à bas et haut indices de réfraction et se terminant par une couche à bas indice de réfraction est préféré. Il peut notamment s'agir d'un empilement décrit dans la demande WO 01/94989 ou WO 2007/077373. Le revêtement antireflet peut également comprendre en dernière couche une couche autonettoyante et antisalissure à base d'oxyde de titane photocatalytique, tel qu'enseigné dans la demande WO 2005/110937. On peut ainsi obtenir une faible réflexion durable dans le temps.

Toujours dans un souci d'optimisation du rendement de la cellule photovoltaïque, la surface du substrat peut être texturée, par exemple présenter des motifs (notamment en pyramide), tel que décrit dans les demandes WO 03/046617, WO 2006/134300, WO 2006/134301 ou encore WO 2007/015017. Ces texturations sont en général obtenues à l'aide d'un formage du verre par laminage.

La couche à base de TCO est de préférence à base ou constituée d'au moins un oxyde choisi parmi les oxydes mixtes d'étain et d'indium, les oxydes mixtes d'indium et de zinc, l'oxyde de zinc dopé avec du gallium et/ou de l'aluminium et/ou du titane et/ou de l'indium, l'oxyde de titane dopé au niobium et/ou au tantale, le stannate de cadmium ou de zinc, l'oxyde d'étain dopé au fluor et/ou à l'antimoine. Les taux de dopage, correspondant au poids d'oxyde de dopant rapporté au poids total sont en général inférieurs à 10%, voire 5%. Dans le cas de l'oxyde de zinc dopé à l'aluminium, le taux de dopage (c'est-à-dire le poids d'oxyde d'aluminium rapporté au poids total) est de préférence inférieur à 3%. Dans le cas de l'oxyde de gallium, le taux de dopage peut être plus élevé, typiquement compris entre 5 et 6%.

La couche à base de TCO est de préférence à base ou constituée d'oxyde de zinc dopé avec du gallium et/ou de l'aluminium et/ou du titane et/ou de l'indium, notamment d'oxyde de zinc dopé à l'aluminium, d'oxyde de zinc dopé au gallium, d'oxyde de zinc dopé au titane, d'oxyde de zinc dopé à l'indium, d'oxyde de zinc codopé avec deux ou plus de ces atomes, par exemple avec du gallium et de l'aluminium, avec de l'aluminium et de l'indium. Ces couches peuvent en effet être obtenues dans de bonnes conditions de productivité par le procédé de pulvérisation cathodique, notamment assisté par champ magnétique (procédé magnétron).

L'épaisseur de la couche à base de TCO est de préférence comprise entre 2 et 1000 nm, notamment entre 50 et 800 nm, voire entre 150 et 600 nm.

La couche à base de TCO traitée selon l'invention peut être la seule couche mince déposée sur le substrat. Elle peut également être comprise dans un empilement de couches minces comprenant des couches minces, généralement choisies parmi des oxydes, des nitrures ou des métaux. Dans le cas où la couche mince traitée est comprise dans un empilement de couches minces, le procédé selon l'invention peut améliorer les propriétés de cristallisation d'une ou de plusieurs couches minces de l'empilement.

La couche à base de TCO peut notamment être comprise dans un empilement de couches comprenant au moins une sous-couche faisant office de barrière à la migration des alcalins et/ou au moins une surcouche faisant office de barrière à l'oxydation. Ce type d'empilements est par exemple décrit dans la demande WO 2007/018951.

Comme sous-couche faisant office de barrière à la migration des alcalins on peut citer des matériaux diélectriques tels que nitrures, oxydes ou oxynitrures de silicium ou d'aluminium ou l'un quelconque de leurs mélanges. La sous-couche évite notamment les effets néfastes de la migration d'ions alcalins sous champ électrique durant le fonctionnement de la cellule photovoltaïque.

De préférence, la couche mince transparente et électro-conductrice n'est pas surmontée d'une surcouche car la rapidité du chauffage pendant le traitement engendre très peu de migration d'oxygène comparativement à un recuit ou une trempe. Cela est d'autant plus avantageux dans le cas où la couche conductrice doit servir d'électrode et doit donc être en contact électrique direct avec d'autres couches fonctionnelles (cas par exemple des applications photovoltaïques ou OLED) : dans le cas d'une trempe ou d'un recuit, la surcouche de protection face à l'oxydation est nécessaire pendant le traitement et doit ensuite être éliminée. Grâce au procédé selon l'invention, il est possible de se passer de cette surcouche. Il a en outre été observé que la présence d'une surcouche diminuait dans certains cas l'efficacité du traitement.

Alternativement ou cumulativement, la couche mince transparente et électroconductrice peut ne pas être déposée sur une sous-couche car la rapidité du chauffage pendant le traitement engendre très peu de migration d'ions alcalins provenant du verre, comparativement à un recuit ou une trempe.

La couche mince transparente et électroconductrice est surmontée, avant le traitement thermique selon l'invention, d'une couche mince à base de carbone. Le carbone est de préférence du type graphite ou amorphe, ou contient un mélange des deux phases, et/ou contient au moins 50%, voire 100% de carbone sp2. La couche mince à base de carbone est de préférence constituée de carbone, mais peut toutefois être dopée avec un métal ou partiellement hydrogénée. L'épaisseur de la couche de carbone est inférieure à 5 nm, notamment 2 nm et même 1 nm. Le carbone étant doté d'une forte capacité d'absorption dans le visible et l'infrarouge, la couche de carbone permet d'augmenter de manière importante l'absorption du rayonnement laser au niveau de la couche à traiter et donc d'accroître l'efficacité du traitement selon l'invention. Il est en particulier possible d'obtenir les mêmes baisses de résistivité qu'en l'absence de couche de carbone, mais avec une vitesse de défilement sous le laser beaucoup plus importante, typiquement de 50% ou 75% supérieure. Alternativement, il est possible, à même vitesse de défilement, d'obtenir des résistivités encore plus faibles. Le carbone, surtout lorsqu'il est majoritairement hybridé sp2, notamment du type graphite ou amorphe, et ce d'autant plus que son épaisseur est faible, est éliminé lors du traitement, probablement par oxydation en dioxyde de carbone, si bien que l'absorption résiduelle après traitement est minime.

La couche mince à base de carbone peut être obtenue par diverses techniques, notamment la pulvérisation cathodique assistée par champ magnétique, par exemple à l'aide d'une cible de graphite sous atmosphère d'argon. D'autres procédés de dépôt incluent le dépôt chimique en phase vapeur (CVD), le dépôt à l'arc, par évaporation, par des procédés de type sol-gel.

Plusieurs dispositifs de rayonnement sont utilisables, du moment qu'ils permettent de focaliser l'énergie sur une zone de petite taille, typiquement sur une zone dont une dimension au moins n'excède pas 10 cm. De préférence, afin d'augmenter encore la densité d'énergie et le coefficient d'échange thermique, une dimension au moins de la zone sur laquelle le rayonnement est focalisé n'excède pas 5 cm, notamment 1 cm, et même 5 mm, voire 1 mm, et même 0,5 mm. L'autre dimension peut également être du même ordre de grandeur (cas par exemple d'un faisceau laser « ponctuel »), ou être beaucoup plus grande (cas par exemple d'un faisceau laser en ligne), comme expliqué plus en détail dans la suite du texte.

La longueur d'onde du rayonnement est comprise entre 500 et 2000 nm, de préférence entre 700 et 1300 nm.

Le ou chaque dispositif de rayonnement est de préférence un laser. Le rayonnement focalisé sur la couche à traiter est dans ce cas un rayonnement laser.

Un laser YAG (grenat d'aluminium et d'yttrium Y₂Al₁₅O₂) dopé au néodyme, émettant, en mode continu ou pulsé, un rayonnement d'environ 1 micromètre de longueur d'onde, est bien adapté, notamment lorsque le substrat n'absorbe pas ou peu dans ce domaine de longueurs d'ondes, ce qui est le cas pour des verres clairs, dont la teneur pondérale en oxyde de fer est de 0,1% ou moins.

On préfère toutefois utiliser des diodes laser, émettant par exemple à une longueur d'onde de l'ordre de 808 nm, 880 nm, 915 ou encore 940 nm ou 980 nm. Sous forme de barrettes de diodes, de très fortes puissances peuvent être obtenues, qui permettent d'atteindre des densités de puissance supérieures à 20 kW/cm², voire 30 kW/cm² au niveau de la couche à traiter. Le verre absorbe moins à ces longueurs d'onde qu'à la longueur d'onde d'émission du laser YAG dopé au néodyme, ce qui permet d'augmenter encore la sélectivité du procédé.

Pour une simplicité de mise en œuvre accrue, les lasers employés dans le cadre de l'invention peuvent être fibrés, ce qui signifie que le rayonnement laser est injecté dans une fibre optique puis délivré près de la surface à traiter par une tête de focalisation. Le laser peut également être à fibre, au sens où le milieu d'amplification est lui-même une fibre optique.

Le faisceau laser peut être ponctuel, auquel cas il est nécessaire de prévoir un système de déplacement du faisceau laser dans le plan du substrat.

Il est toutefois préférable d'utiliser un dispositif de rayonnement émettant un faisceau laser en ligne irradiant simultanément toute ou partie de la largeur du substrat. Ce mode est préféré car il évite l'utilisation de systèmes de déplacement coûteux, généralement encombrants, et d'entretien délicat. Le faisceau laser en ligne peut notamment être obtenu à l'aide de barrettes de diodes laser de forte puissance associées à une optique de focalisation. L'épaisseur de la ligne est de préférence comprise entre 0,004 et 1 mm. La longueur de la ligne est typiquement comprise entre 5 mm et 1 m. Le profil de la ligne peut notamment être une courbe de Gauss ou un créneau.

La ligne laser irradiant simultanément toute ou partie de la largeur du substrat peut être composée d'une seule ligne (irradiant alors toute la largeur du substrat), ou de plusieurs lignes, éventuellement disjointes. Lorsque plusieurs lignes sont utilisées, il est préférable qu'elles soient disposées de sorte que toute la surface de la couche soit traitée. La ou chaque ligne est de préférence disposée perpendiculairement à la direction de défilement du substrat, ou disposée de manière oblique. Les différentes lignes peuvent traiter le substrat simultanément, ou de manière décalée dans le temps. L'important est que toute la surface à traiter le soit.

Afin de traiter toute la surface désirée, il est également préférable de prévoir un déplacement relatif entre d'une part le substrat revêtu de la couche et d'autre part le dispositif de rayonnement, notamment la ou chaque ligne laser. Le substrat peut ainsi être mis en déplacement, notamment en défilement en translation en regard du dispositif de rayonnement fixe (notamment de la ligne laser fixe), généralement en dessous, mais éventuellement au-dessus de la ligne laser. Ce mode de réalisation est particulièrement appréciable pour un traitement en continu. Alternativement, le substrat peut être fixe et le dispositif de rayonnement (notamment le laser) peut être mobile. De préférence, la différence entre les vitesses respectives du substrat et du dispositif de rayonnement (notamment du laser) sont supérieures ou égales à 1 mètre par minute, voire 4 et même 8 mètres par minute, ce afin d'assurer une grande vitesse de traitement.

Lorsque le substrat est en déplacement, notamment en translation, il peut être mis en mouvement à l'aide de tous moyens mécaniques de convoyage, par exemple à l'aide de bandes, de rouleaux, de plateaux en translation. Le système de convoyage permet de contrôler et réguler la vitesse du déplacement. Si le substrat en matière organique polymérique souple, le déplacement peut être réalisé à l'aide d'un système d'avance de films sous forme d'une succession de rouleaux.

Le laser peut également être mis en mouvement de manière à ajuster sa distance au substrat, ce qui peut être utile en particulier lorsque le substrat est bombé, mais pas seulement. En effet, il est préférable que le faisceau laser soit focalisé sur le revêtement à traiter de sorte que ce dernier soit situé à une distance inférieure ou égale à 1 mm du plan focal. Si le système de déplacement du substrat ou du laser n'est pas suffisamment précis quant à la distance entre le substrat et le plan focal, il convient de préférence de pouvoir ajuster la distance entre le laser et le substrat. Cet ajustement peut être automatique, notamment régulé grâce à une mesure de la distance en amont du traitement.

Lorsque la ligne laser est en déplacement, il faut prévoir un système de déplacement du laser, situé au-dessus ou en dessous du substrat. La durée du traitement est régulée par la vitesse de déplacement de la ligne laser.

Toutes les positions relatives du substrat et du laser sont bien entendu possibles, du moment que la surface du substrat peut être convenablement irradiée. Le substrat sera le plus généralement disposé de manière horizontale, mais il peut aussi être disposé verticalement, ou selon toute inclinaison possible. Lorsque le substrat est disposé horizontalement, le laser est généralement disposé de manière à irradier la face supérieure du substrat. Le laser peut également irradier la face inférieure du substrat. Dans ce cas, il faut que le système de support du substrat, éventuellement le système de convoyage du substrat lorsque ce dernier est en mouvement, laisse passer le rayonnement dans la zone à irradier. C'est le cas par exemple lorsque l'on utilise des rouleaux de convoyage : les rouleaux étant disjoints, il est possible de disposer le laser dans une zone située entre deux rouleaux successifs.

Lorsque les deux faces du substrat sont à traiter, il est possible d'employer plusieurs lasers situés de part et d'autre du substrat, que ce dernier soit en position horizontale, verticale, ou selon toute inclinaison.

Le rayonnement peut, alternativement ou cumulativement, être issu de lampes infrarouges associées à un dispositif de focalisation. Le dispositif de focalisation peut être par exemple comprendre au moins une lentille ou au moins un miroir, par exemple un miroir parabolique. Cette focalisation permet de concentrer l'énergie de la lampe sur une zone réduite du substrat, permettant ainsi d'atteindre des densités d'énergie importantes.

Le dispositif de rayonnement, par exemple le laser en ligne, peut être intégré dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD). La ligne comprend en général des dispositifs de manutention des substrats, une installation de dépôt, des dispositifs de contrôle optique, des dispositifs d'empilage. Les substrats défilent, par exemple sur des rouleaux convoyeurs, successivement devant chaque dispositif ou chaque installation.

Le dispositif de rayonnement, par exemple le laser en ligne, est de préférence situé juste après l'installation de dépôt de la couche, par exemple à la sortie de l'installation de dépôt. Le substrat revêtu peut ainsi être traité en ligne après le dépôt de la couche, à la sortie de l'installation de dépôt et avant les dispositifs de contrôle optique, ou après les dispositifs de contrôle optique et avant les dispositifs d'empilage des substrats.

Le dispositif de rayonnement peut aussi être intégré à l'installation de dépôt. Par exemple, le dispositif (notamment le laser) peut être introduit dans une des chambres d'une installation de dépôt par pulvérisation cathodique, notamment dans une chambre où le vide est raréfié, notamment sous une pression comprise entre 10⁻⁶ mbar et 10⁻² mbar. Le laser peut aussi être disposé en dehors de l'installation de dépôt, mais de manière à traiter un substrat situé à l'intérieur de ladite installation. Il suffit de prévoir à cet effet un hublot transparent à la longueur d'onde du rayonnement utilisé, au travers duquel le rayon laser viendrait traiter la couche. Il est ainsi possible de traiter une couche avant le dépôt subséquent d'une autre couche dans la même installation.

Que le dispositif de rayonnement soit en dehors de ou intégré à l'installation de dépôt, ces procédés « en ligne » sont préférables à un procédé en reprise dans lequel il serait nécessaire d'empiler les substrats de verre entre l'étape de dépôt et le traitement thermique.

Les procédés en reprise peuvent toutefois avoir un intérêt dans les cas où la mise en œuvre du traitement thermique selon l'invention est faite dans un lieu différent de celui où est réalisé le dépôt, par exemple dans un lieu où est réalisée la transformation du verre. Le dispositif de rayonnement peut donc être intégré à d'autres lignes que la ligne de dépôt de couches. Il peut par exemple être intégré à une ligne de fabrication de vitrages multiples (doubles ou triples vitrages notamment), ou à une ligne de fabrication de vitrages feuilletés. Dans ces différents cas, le traitement thermique selon l'invention est de préférence réalisé avant la réalisation du vitrage multiple ou feuilleté. Le dispositif de rayonnement peut également être intégré à une ligne de fabrication de cellules photovoltaïques, par exemple pour diminuer la résistivité de couches minces électro-conductrices servant d'électrodes.

Le dépôt de la couche mince sur le substrat peut être réalisé par tout type de procédé, en particulier des procédés générant des couches majoritairement amorphes ou nano-cristallisées, tels que le procédé de pulvérisation cathodique, notamment assisté par champ magnétique (procédé magnétron), le procédé de dépôt chimique en phase vapeur assisté par plasma (PECVD), le procédé d'évaporation sous vide, ou le procédé sol-gel. La couche mince obtenue est toutefois de préférence une couche « sèche », ne contenant pas de solvant aqueux ou organique, en opposition avec une couche « humide », par exemple obtenue par le procédé sol-gel.

Dans le cas d'une couche obtenue par le procédé sol-gel, des précurseurs en solution (sol) sont déposés sur le substrat, la couche obtenue devant ensuite être séchée et recuite pour éliminer toute trace de solvant. Dans ce cas, l'énergie apportée par le chauffage sert alors majoritairement à éliminer ce solvant, sans affecter les propriétés de cristallisation de la couche, et il est par conséquent plus difficile d'améliorer lesdites propriétés en un temps suffisamment court pour ne pas chauffer également le substrat.

Le dépôt de la couche mince est de préférence réalisé par pulvérisation cathodique, notamment assistée par champ magnétique (procédé magnétron).

Pour plus de simplicité, le traitement thermique de la couche se fait de préférence sous air et/ou à pression atmosphérique. Il est toutefois possible de procéder au traitement thermique de la couche au sein même de l'enceinte de dépôt sous vide, par exemple avant un dépôt subséquent.

Le traitement thermique est de préférence tel que l'on porte chaque point de la couche mince à une température d'au moins 300°C en maintenant une température inférieure ou égale à 100°C en tout point de la face dudit substrat opposée à ladite première face, de manière à augmenter le taux de cristallisation de ladite couche mince en la conservant continue et sans étape de fusion de ladite couche mince. La couche à base de TCO reste donc continue à l'issue du traitement.

Par « couche mince continue », on entend au sens de la présente invention que la couche recouvre sensiblement la totalité du substrat ou, dans le cas d'un empilement, la totalité de la couche sous-jacente. Il est important que le caractère continu de la couche mince (et donc ses propriétés avantageuses) soit préservé par le traitement selon l'invention.

Par « point de la couche », on entend une zone de la couche subissant le traitement à un instant donné. Selon l'invention, la totalité de la couche (donc chaque point) est portée à une température d'au moins 300°C, mais chaque point de la couche n'est pas nécessairement traité simultanément. La couche peut être traitée au même instant dans son ensemble, chaque point de la couche étant simultanément porté à une température d'au moins 300°C. La couche peut alternativement être traitée de manière à ce que les différents points de la couche ou des ensembles de points soient successivement portés à une température d'au moins 300°C, ce deuxième mode étant plus souvent employé dans le cas d'une mise en œuvre continue à l'échelle industrielle.

Le procédé selon l'invention peut être mis en œuvre sur un substrat placé aussi bien horizontalement que verticalement. Il peut également être mis en œuvre sur un substrat pourvu de couches minces sur ses deux faces, au moins une couche d'une des faces ou de chaque face étant traitée selon l'invention. Dans le cas où des couches minces déposées sur les deux faces du substrat sont traitées selon l'invention, il est possible de traiter lesdites couches minces de chaque face soit simultanément, soit successivement, par des techniques identiques ou distinctes, en particulier selon que la nature des couches traitées est identique ou distincte. Le cas où le traitement selon l'invention est réalisé simultanément sur les deux faces du substrat est donc bien compris dans la portée de l'invention.

Le procédé selon l'invention peut également comprendre, après l'étape de traitement thermique, une étape de trempe thermique, qui a pour effet de réduire encore la résistivité de la couche à base de TCO.

L'invention a encore pour objet les matériaux susceptibles d'être obtenus par le procédé selon l'invention.

Le procédé selon l'invention permet en effet d'obtenir des couches à base de TCO dont la très faible résistivité ne pouvait être obtenue que par des traitements thermiques au moment du dépôt, par exemple un dépôt par pulvérisation cathodique réalisé sur un substrat chauffé à plus de 300°C.

Un matériau selon l'invention est constitué d'un substrat revêtu d'au moins une couche mince transparente conductrice à base d'oxydes mixtes d'indium et de zinc ou d'étain, d'oxyde de zinc dopé à l'aluminium ou au gallium, à base d'oxyde de titane dopé au niobium, à base de stannate de cadmium et/ou de zinc, à base d'oxyde d'étain dopé au fluor et/ou à l'antimoine.

En particulier, un matériau particulièrement intéressant, qui n'a pu être obtenu par les techniques jusqu'alors connues, consiste en un substrat en verre non-trempé ou en matière plastique organique, revêtu d'au moins une couche à base d'oxyde de zinc dopé à l'aluminium et/ou au gallium. Ce matériau est caractérisé en ce que la couche présente une résistivité d'au plus 6.10⁻⁴ Ohm.cm, une absorption inférieure ou égale à 1,2% pour une épaisseur de couche de 100 nm et une morphologie superficielle présentant des grains ayant une dimension comprise entre 100 et 200 nm, eux même fragmentés en une pluralité de grains élémentaires, notamment en au moins deux, trois ou quatre grains élémentaires. Une telle morphologie est visible par microscopie électronique à balayage, notamment en grossissement x 100000. Le terme de grain ne préjuge pas de la dimension des cristallites ou des domaines cohérents de diffraction des rayons X.

L'absorption lumineuse de la couche est définie comme étant égale à la valeur de 100% à laquelle sont soustraites la transmission lumineuse du substrat revêtu, la réflexion lumineuse côté substrat (côté de la face opposée à la couche) et l'absorption lumineuse du substrat non-revêtu. L'absorption lumineuse du substrat non-revêtu correspond quant à elle à la valeur de 100% à laquelle sont soustraites la transmission lumineuse et la réflexion lumineuse du substrat non revêtu. Comme dans l'ensemble du texte, les transmissions lumineuses et les réflexions lumineuses sont calculées selon la norme ISO 9050 :2003 à partir respectivement des spectres en transmission et réflexion.

La résistance carrée de la couche peut être mesurée de manière connue à l'aide de la méthode 4-pointes ou méthode de Van der Pauw. L'épaisseur de la couche peut être déterminée notamment à l'aide d'un profilomètre. La résistivité de la couche se calcule alors en multipliant la résistance carrée et l'épaisseur.

Les traitements de recuit de l'art antérieur ne permettaient au mieux d'obtenir que des résistivités de 7,5.10⁻⁴ Ohm.cm, soit une résistance carrée de 10 Ohms pour une épaisseur de 750 nm. Les grains ont des dimensions comprises entre 100 et 200 nm, mais ne sont pas fragmentés.

Le dépôt par pulvérisation cathodique sur un substrat chauffé à au moins 300°C permet d'obtenir des valeurs de résistivité comprises entre 2,5 et 5.10⁻⁴ Ohm.cm. Les grains obtenus ont des dimensions importantes, supérieures à 150 nm, mais ne sont pas fragmentés.

La morphologie unique obtenue par le traitement selon l'invention est particulièrement surprenante : on pourrait penser que la fragmentation des grains aurait pour effet de diminuer la mobilité des porteurs de charge et donc d'augmenter la résistivité. C'est pourtant le contraire qui se produit.

Les matériaux selon l'invention peuvent bien évidemment présenter l'une quelconque des caractéristiques décrites dans l'ensemble du texte (type de substrat, nature des couches ou des éventuelles sous-couches ou surcouches, épaisseur), seule ou en combinaison avec d'autres caractéristiques qui y sont également décrites. En particulier, les différentes caractéristiques des matériaux obtenus décrites en relation avec le procédé selon l'invention sont bien évidemment également applicables au matériau selon l'invention.

Les substrats (obtenus) selon l'invention peuvent être utilisés dans des vitrages simples, multiples ou feuilletés, des miroirs, des revêtements muraux en verre.

Dans le cas d'un vitrage multiple comportant au moins deux feuilles de verre séparées par une lame de gaz, il est préférable que la couche mince soit disposée sur la face en contact avec ladite lame de gaz. Disposer la couche mince en face externe du vitrage (donc en contact avec l'extérieur du bâtiment), notamment dans le cas d'un triple vitrage ou d'un double vitrage incliné (par exemple intégré à une toiture ou une véranda) est toutefois avantageux, car la faible émissivité de ces couches permet d'éviter un refroidissement trop important de la surface du vitrage pendant la nuit, et par conséquent d'éviter l'apparition de condensation (buée et/ou givre).

Les substrats (obtenus) selon l'invention sont de préférence utilisés dans des cellules ou vitrages photovoltaïques ou des panneaux solaires, la couche mince traitée selon l'invention étant par exemple une électrode à base de ZnO : Al ou Ga dans des empilements à base de chalcopyrites (notamment du type CIS - CuInSe₂) ou à base de silicium amorphe et/ou polycristallin, ou encore à base de CdTe.

Dans la cellule ou le vitrage photovoltaïque, le substrat selon l'invention est de préférence le substrat de face avant. Il est généralement orienté de telle façon que la couche transparente électro-conductrice, qui sert de revêtement électrode transparent, est situé en dessous d'une surface principale tournée vers le matériau photovoltaïque. Ce revêtement électrode est en contact électrique avec le matériau photovoltaïque disposé dessous lorsque l'on considère que la direction principale d'arrivée du rayonnement incident est par le dessus.

Ce revêtement électrode de face avant constitue ainsi, en général, la borne négative (ou collectant les trous) ou positive (collectant les électrons) de la cellule solaire, selon les technologies employées. Bien sûr, la cellule solaire comporte aussi sur le substrat de face arrière un revêtement électrode qui constitue alors la borne positive, respectivement négative, de la cellule solaire, mais en général, le revêtement électrode du substrat de face arrière n'est pas transparent.

Les substrats selon l'invention peuvent aussi être utilisés dans des écrans de visualisation du type LCD (Liquid Crystal Display), OLED (Organic Light Emitting Diodes) ou FED (Field Emission Display), la couche mince traitée selon l'invention étant par exemple une couche électroconductrice en ITO. Ils peuvent encore être utilisés dans des vitrages électrochromes, la couche mince traitée selon l'invention étant par exemple une couche électro-conductrice transparente tel qu'enseignée dans la demande FR-A-2 833 107.

L'invention a donc aussi pour objet des vitrages ou cellules photovoltaïques, panneaux solaires, écrans de visualisation du type LCD (Liquid Crystal Display), OLED (Organic Light Emitting Diodes) ou FED (Field Emission Display), vitrages électrochromes comprenant au moins un substrat selon l'invention.

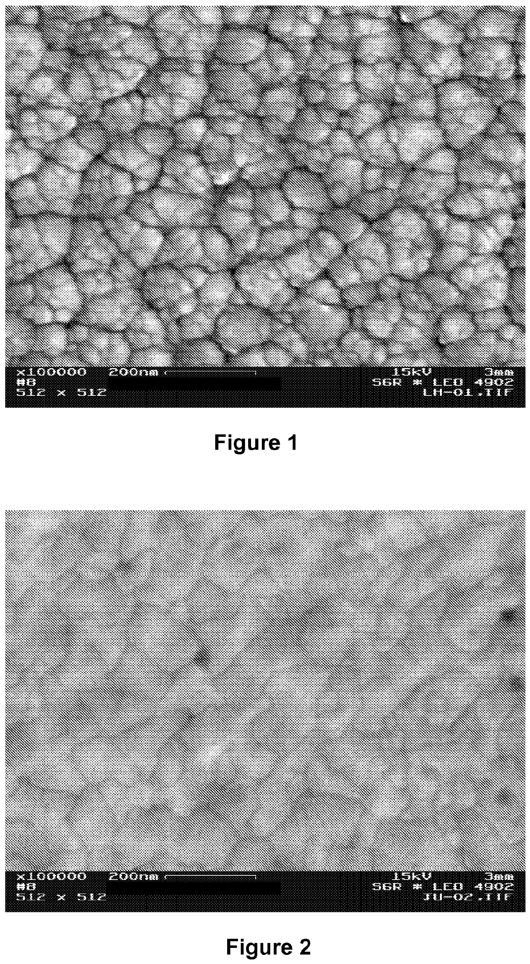

La Figure 1 est un cliché de microscopie électronique à balayage d'une couche mince d'oxyde de zinc dopé à l'aluminium traitée selon l'invention.
La Figure 2 est un cliché de microscopie électronique à balayage d'une couche mince d'oxyde de zinc dopé à l'aluminium déposée sur un substrat chauffé à 300°C pendant le dépôt.

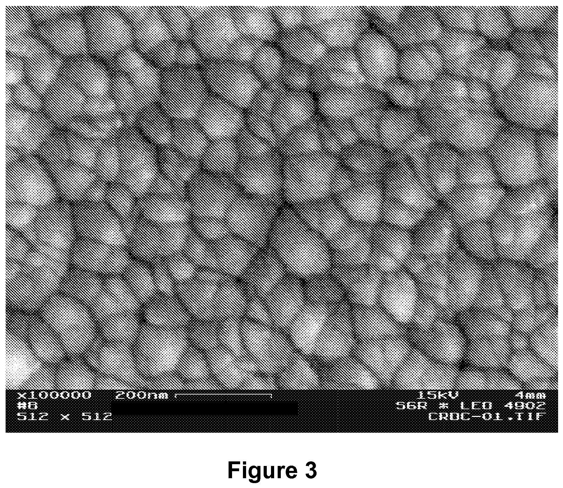

La Figure 3 est un cliché de microscopie électronique à balayage d'une couche mince d'oxyde de zinc dopé à l'aluminium recuite par les procédés de recuit traditionnels.

On peut voir en comparant ces figures que le traitement selon l'invention permet d'obtenir une morphologie très particulière, dans laquelle on distingue des grains dont une dimension est comprise entre 100 et 200 nm, fragmentés en plusieurs grains élémentaires.

L'invention est illustrée à l'aide des exemples de réalisation non limitatifs qui suivent.

### EXEMPLE 1 (COMPARATIF):

Cet exemple correspond à l'exemple 12 de la demande WO 2008/096089. Une couche transparente conductrice à base d'oxyde de zinc dopé avec de l'aluminium d'épaisseur 190 nm est déposée sur un substrat en verre par un procédé magnétron.

La couche est irradiée à l'aide d'un laser CO₂ émettant un rayonnement de 10,6 micromètres de longueur d'onde. Le laser est monté sur un système permettant un déplacement rapide du laser dans une direction perpendiculaire à la direction de défilement du substrat de manière à ce que toute la surface de la couche soit concernée par le traitement. La largeur du spot sur la surface de la couche est d'environ 0,3 à 0,5 mm.

Le tableau 1 ci-après indique les valeurs de résistance carrée et de transmission lumineuse avant et après traitement.

**Tableau 1**

| Transmission (%) | | R_{c} (Ω) | |
|---|---|---|---|
| avant | après | avant | après |
| 74,4 | 78,3 | 94,8 | 40,5 |

La résistivité obtenue a donc diminué de 57% grâce au traitement, atteignant une valeur de 7,7.10⁻⁴ Ω.cm.

### EXEMPLES 2 à 5 (COMPARATIFS):

Dans ces exemples, on dépose des couches TCO du type oxyde de zinc dopé à l'aluminium. Ces couches sont déposées par pulvérisation cathodique magnétron sur des substrats de 3 mm d'épaisseur et de verre extra-clair commercialisés par la société Saint-Gobain Glass France sous la marque SGG Diamant®. Le dépôt est réalisé de manière connue à l'aide d'une cible en oxyde de zinc dopé aluminium sous atmosphère d'argon (pulvérisation non réactive).

Les substrats revêtus sont ensuite traités thermiquement à l'aide d'un laser en ligne de puissance 450 W. Le laser est fixe et le substrat revêtu défile sous le laser à des vitesses allant de 3 à 9 mètres par minute. La longueur d'onde du laser est de 808 nm. Des essais ont également été réalisés à l'aide d'un laser émettant à 980 nm. Le laser en ligne est obtenu à partir de barrettes de diodes laser. Pendant le traitement, la température de la face du substrat opposée à la couche ne dépasse pas 50°C.

Le tableau 2 ci-après indique pour chaque exemple :
- l'épaisseur de la couche en nm,
- le taux de dopage (teneur massique en Al₂O₃),
- la vitesse de défilement du substrat sous le laser (en mètres par minute),
- la résistance carrée avant et après traitement, notée R_{c} et exprimée en Ohms,
- la résistivité obtenue grâce au traitement, exprimée en Ohm.cm,
- la transmission lumineuse du substrat revêtu, notée T_{L} et calculée selon la norme ISO 9050 :2003, exprimée en %,
- l'absorption lumineuse de la couche, notée A_{L} et exprimée en %.

**Tableau 2**

| | 2 | 3 | 4 | 5 |
|---|---|---|---|---|
| Epaisseur (nm) | 550 | 700 | 500 | 800 |
| Taux de dopage (%) | 2 | 2 | 1 | 2 |
| Vitesse (m/min) | 7 | 9 | 3 | 8 |
| R_{c} (Ω) avant traitement | 26,5 | 21,6 | 28,7 | 18,7 |
| R_{c} (Ω) après traitement | 5,9 | 5,6 | 9,2 | 5,2 |
| Résistivité (Ω.cm) | 3,2.10⁻⁴ | 3,9.10⁻⁴ | 4,6.10⁻⁴ | 4,2.10⁻⁴ |
| T_{L} (%) | 82,7 | 82,9 | 81,0 | 83,9 |
| A_{L} (%) | 4,6 | 4,9 | 5,7 | 4,6 |

Ces exemples montrent que le traitement selon l'invention permet d'obtenir des résistivités bien moindres (souvent d'un facteur proche de deux) que celles obtenues par le procédé connu de WO 2008/096089. Les résistivités et résistances carrées chutent d'environ 70% relativement à leurs valeurs initiales. Les transmissions lumineuses sont également plus élevées, ce qui est particulièrement appréciable pour les applications photovoltaïques.

### EXEMPLE 6 (COMPARATIF):

Dans cet exemple, on dépose sur une feuille de verre une couche d'oxyde d'étain et d'indium (ITO) par pulvérisation cathodique magnétron. L'épaisseur de la couche est de 500 nm.

Le traitement thermique est similaire à celui subi par les exemples 2 à 5.

Avant traitement, la résistance carrée est de 15 Ohms, et chute à environ 4 à 5 Ohms suite au traitement.

### EXEMPLES 7 à 11

Les substrats revêtus des exemples 2 à 6 sont à leur tour revêtus d'une couche mince en carbone obtenue par pulvérisation cathodique magnétron, dont l'épaisseur est de l'ordre de 1 ou 2 nm. La pulvérisation est réalisée à l'aide d'une cible en graphite, sous un plasma d'argon.

La baisse de résistance carrée est d'environ 70 à 75%, comme pour les exemples 2 à 6, mais pour une vitesse de défilement du substrat sous le laser d'environ 50 à 60% plus élevée.

Après le traitement thermique la couche de carbone n'est plus visible, e carbone ayant vraisemblablement été oxydé en dioxyde de carbone gazeux.

La couche de carbone permet donc d'obtenir des gains de productivité très appréciables.

## Revendications

1. Procédé d'obtention d'un substrat revêtu sur une première face d'au moins une couche mince transparente et électro-conductrice à base d'au moins un oxyde, comprenant les étapes suivantes :
- on dépose ladite au moins une couche mince sur ledit substrat,
- on soumet ladite au moins une couche mince à une étape de traitement thermique dans laquelle on irradie ladite au moins une couche à l'aide d'un rayonnement possédant une longueur d'onde comprise entre 500 et 2000 nm et focalisé sur une zone de ladite au moins une couche dont une dimension au moins n'excède pas 10 cm, ledit rayonnement étant issu d'au moins un dispositif de rayonnement placé en regard de ladite au moins une couche, un déplacement relatif étant créé entre ledit dispositif de rayonnement et ledit substrat de manière à traiter la surface souhaitée, ledit traitement thermique étant tel que la résistivité de ladite au moins une couche est diminuée lors du traitement **caractérisé en ce que** ladite au moins une couche mince est surmontée, avant l'étape de traitement thermique, d'une couche mince à base de carbone d'épaisseur inférieure à 5 nm.

2. Procédé selon la revendication 1, tel que la résistivité de la couche transparente et électro-conductrice, ou sa résistance carrée, est diminuée d'au moins 60%, voire 70% et même 75% relativement à la résistivité ou à la résistance carrée mesurée avant traitement thermique.

3. Procédé selon l'une des revendications précédentes, tel que le substrat est en verre ou en matière organique polymérique.

4. Procédé selon l'une des revendications précédentes, tel que ladite au moins une couche mince est à base d'au moins un oxyde choisi parmi les oxydes mixtes d'étain et d'indium, les oxydes mixtes d'indium et de zinc, l'oxyde de zinc dopé avec du gallium et/ou de l'aluminium et/ou du titane et/ou de l'indium, l'oxyde de titane dopé au niobium et/ou au tantale, le stannate de cadmium ou de zinc, l'oxyde d'étain dopé au fluor et/ou à l'antimoine.

5. Procédé selon la revendication précédente, tel que ladite au moins une couche mince présente après traitement thermique une résistivité inférieure ou égale à 7.10⁻⁴ Ohm.cm, notamment 6.10⁻⁴ Ohm.cm, et une absorption inférieure ou égale à 1,2%, notamment 1% pour une épaisseur de couche de 100 nm.

6. Procédé selon l'une des revendications précédentes, tel que le carbone est du type graphite ou amorphe ou un mélange des deux et/ou contient au moins 50% de carbone sp2.

7. Procédé selon l'une des revendications précédentes, tel que la température de la face dudit substrat opposée à ladite première face n'excède pas 100°C, voire 50°C, et notamment 30°C, pendant le traitement thermique.

8. Procédé selon l'une des revendications précédentes, tel que la puissance surfacique du rayonnement est supérieure ou égale à 10 kW/cm².

9. Procédé selon l'une des revendications précédentes, tel qu'une dimension au moins de la zone sur laquelle le rayonnement est focalisé n'excède pas 5 cm, notamment 1 cm, et même 5 mm, voire 1 mm, et même 0,5 mm.

10. Procédé selon l'une des revendications précédentes, dans lequel le ou chaque dispositif de rayonnement est un laser.

11. Procédé selon la revendication précédente, tel que le dispositif de rayonnement émet un faisceau laser en ligne irradiant simultanément toute ou partie de la largeur du substrat.

12. Procédé selon l'une des revendications précédentes, tel que le dépôt de la au moins une couche mince est réalisé par pulvérisation cathodique assistée par champ magnétique.

## Patentansprüche

1. Verfahren zum Erhalten eines beschichteten Substrats auf einer ersten Fläche von mindestens einem transparenten und elektrisch leitenden dünnen Film auf Basis von mindestens einem Oxid, umfassend die folgenden Schritte:
- Abscheiden des mindestens einen dünnen Films auf das Substrat,
- Auftragen des mindestens einen dünnen Films bei einem Wärmebehandlungsschritt, in dem der mindestens eine Film mithilfe einer Strahlung mit einer Wellenlänge im Bereich zwischen 500 und 2.000 nm bestrahlt wird und auf eine Zone des mindestens einen Films fokussiert wird, von der mindestens eine Abmessung 10 cm nicht überschreitet, wobei die Strahlung aus mindestens einer Strahlungsvorrichtung kommt, die gegenüber des mindestens einen Films platzierten ist, wobei zwischen der Strahlungsvorrichtung und dem Substrat eine relative Verschiebung auf eine Weise erzeugt wird, um die gewünschte Oberfläche zu behandeln, wobei die Wärmebehandlung derart ist, dass der spezifische Widerstand des mindestens einen Films während der Behandlung verringert wird, **dadurch gekennzeichnet, dass** der mindestens eine dünne Film vor dem Wärmebehandlungsschritt von einem dünnen Film auf Basis von Kohlenstoff mit einer Dicke von weniger als 5 nm bedeckt wird.

2. Verfahren nach Anspruch 1, wobei der spezifische Widerstand des transparenten und elektrisch leitenden Films oder sein Flächenwiderstand bezüglich des vor der Wärmebehandlung gemessenen spezifischen Widerstands oder Flächenwiderstands um mindestens 60 % oder sogar 70 % und sogar 75 % verringert wird.

3. Verfahren nach einem der vorstehenden Ansprüche, wobei das Substrat aus Glas oder einem organischen polymeren Material besteht.

4. Verfahren nach einem der vorstehenden Ansprüche, wobei der mindestens eine dünne Film auf Basis von mindestens einem Oxid ist, das ausgewählt ist aus gemischten Oxiden von Zinn und Indium, gemischten Oxiden von Indium und Zink, mit Gallium und/oder Aluminium und/oder Titan und/oder Indium dotiertem Zinkoxid, niob- und/oder tantaldotiertem Titanoxid, Cadmium- oder Zinkstannat, fluor- und/oder antimondotiertem Zinnoxid.

5. Verfahren nach dem vorstehenden Anspruch, wobei der mindestens eine dünne Film nach der Wärmebehandlung für eine Filmdicke von 100 nm einen spezifischen Widerstand von weniger als oder gleich 7.10⁻⁴ Ohm.cm, insbesondere 6.10⁻⁴ Ohm.cm, und eine Absorption von weniger als oder gleich 1,2 %, insbesondere 1 %, aufweist.

6. Verfahren nach einem der vorstehenden Ansprüche, wobei der Kohlenstoff vom Graphittyp oder amorph oder eine Mischung aus den zwei ist und/oder mindestens 50 % sp2-Kohlenstoff enthält.

7. Verfahren nach einem der vorstehenden Ansprüche, wobei die Temperatur der Fläche des Substrats, die der ersten Fläche gegenüberliegt, während der Wärmebehandlung 100 °C oder sogar 50 °C und insbesondere 30 °C nicht überschreitet.

8. Verfahren nach einem der vorstehenden Ansprüche, wobei die flächenbezogene Leistung der Strahlung mehr als oder gleich 10 kW/cm² beträgt.

9. Verfahren nach einem der vorstehenden Ansprüche, wobei mindestens eine Abmessung der Zone, auf die die Strahlung fokussiert wird, 5 cm, insbesondere 1 cm und sogar 5 mm oder sogar 1 mm und sogar 0,5 mm nicht überschreitet.

10. Verfahren nach einem der vorstehenden Ansprüche, wobei die oder jede Strahlungsvorrichtung ein Laser ist.

11. Verfahren nach dem vorstehenden Anspruch, wobei die Strahlungsvorrichtung einen Laserstrahl in Reihe emittiert, der gleichzeitig alles oder einen Teil der Breite des Substrats bestrahlt.

12. Verfahren nach einem der vorstehenden Ansprüche, wobei die Abscheidung des mindestens einen dünnen Films durch Kathodenzerstäubung unterstützt von Magnetfeld durchgeführt wird.

## Claims

1. A method of obtaining a substrate coated on a first face with at least one transparent and electrically conductive thin layer based on at least one oxide, comprising the following steps:
- said at least one thin layer is deposited on said substrate,
- said at least one thin layer is subjected to a heat treatment step in which said at least one layer is irradiated with the aid of radiation having a wavelength of between 500 and 2000 nm and focused on a zone of said at least one layer, at least one dimension of which does not exceed 10 cm, said radiation being delivered by at least one radiation device placed facing said at least one layer, a relative displacement being created between said radiation device and said substrate so as to treat the desired surface, said heat treatment being such that the resistivity of said at least one layer is reduced during the treatment, **characterized in that** said at least one thin layer is covered before the heat treatment step with a thin layer based on carbon having a thickness of less than 5 nm.

2. The method as claimed in claim 1, such that the resistivity of the transparent and electrically conductive layer, or its sheet resistance, is reduced by at least 60%, or 70% and even 75% relative to the resistivity or the sheet resistance measured before heat treatment.

3. The method as claimed in one of the preceding claims, such that the substrate is made of glass or organic polymer material.

4. The method as claimed in one of the preceding claims, such that said at least one thin layer is based on at least one oxide selected from among the mixed oxides of indium and tin, the mixed oxides of indium and zinc, zinc oxide doped with gallium and/or aluminum and/or titanium and/or indium, titanium oxide doped with niobium and/or tantalum, cadmium or zinc stannate, tin oxide doped with fluorine and/or antimony.

5. The method as claimed in the preceding claim, such that said at least one thin layer has after the heat treatment a resistivity of less than or equal to 7.10⁻⁴ ohm.cm, in particular 6.10⁻⁴ ohm.cm, and an absorption less than or equal to 1.2%, in particular 1%, for a layer thickness of 100 nm.

6. The method as claimed in one of the preceding claims, such that the carbon is of the graphite or amorphous type or a mixture of these two phases, and/or contains at least 50% of sp2 carbon.

7. The method as claimed in one of the preceding claims, such that the temperature of the opposite face of said substrate from said first face does not exceed 100°C, or 50°C, and in particular 30°C, during the heat treatment.

8. The method as claimed in one of the preceding claims, such that the surface power density of the radiation is greater than or equal to 10 kW/cm².

9. The method as claimed in one of the preceding claims, such that at least one dimension of the zone onto which the radiation is focused does not exceed 5 cm, in particular 1 cm, and even 5 mm, or 1 mm, and even 0.5 mm.

10. The method as claimed in one of the preceding claims, in which the or each radiation device is a laser.

11. The method as claimed in the preceding claim, such that the radiation device emits a linear laser beam simultaneously irradiating all or part of the width of the substrate.

12. The method as claimed in one of the preceding claims, such that the at least one thin layer is deposited by magnetic field enhanced cathode sputtering.
